(19) Europäisches Patentamt
European Patent Office
Office européen des brevets

(11) Publication number: **0 029 635**
**B1**

(12) **EUROPEAN PATENT SPECIFICATION**

(45) Date of publication of patent specification: **01.08.84**

(51) Int. Cl.$^3$: **H 03 J 1/02**, G 01 D 13/10

(21) Application number: **80301138.6**

(22) Date of filing: **09.04.80**

(54) **Display unit with a removable indicator panel.**

(30) Priority: **20.11.79 JP 161399/79**
**10.03.80 JP 31618/80**
**10.03.80 JP 31619/80**
**11.03.80 JP 31907/80**

(43) Date of publication of application:
**03.06.81 Bulletin 81/22**

(45) Publication of the grant of the patent:
**01.08.84 Bulletin 84/31**

(84) Designated Contracting States:
**DE GB**

(56) References cited:
DE-A-2 056 416
DE-A-2 314 626
DE-A-2 731 825
DE-A-2 747 879
DE-B-1 220 914
DE-B-1 766 550
DE-C- 924 518
GB-A-1 101 619

(73) Proprietor: **SANYO ELECTRIC CO., LTD.**
**18, Keihanhondori 2-chome**
**Moriguchi-shi Osaka-fu (JP)**

(72) Inventor: **Shirasaka, Susumu**
**4-25 Kusaka-cho 4-chome**
**Higashi Osaka-shi Osaka-fu (JP)**

(74) Representative: **Gura, Henry Alan et al,**
**MEWBURN ELLIS & CO. 2/3 Cursitor Street**
**London EC4A 1BQ (GB)**

(56) References cited:
US-A-1 751 426
US-A-2 871 450
US-A-3 557 748
US-A-4 118 991

**EP 0 029 635 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a display unit and, more particularly, to an assembly of the display unit with a removable indicator panel, in which the unit has a casing formed with a recess or opening in which the panel is adapted to be mounted from the exterior and to be held in place by engagement means in the casing and by a support member.

Various machines and devices have control switches and buttons provided in association with a display unit showing the mode of the controlled state on its indicator panel. In the field of audio devices, for example, a tuner will have a tuning knob and a display unit for showing a station selected by the tuning knob. In the case where the display unit of the tuner comprises an elongate dial plate and an indicator pointer, the elongate dial plate usually extends horizontally. However, due to the layout of the dial plate and the space provided for the tuner, the elongate dial plate is sometimes held vertically. For example, in the case where the audio device is to be installed in a vehicle dash-board, the elongate dial plate may be installed vertically in one vehicle model and, horizontally in another vehicle model, depending on the layout of various indicators on the dash-board. For this purpose, the audio manufacturer has to make two types of audio devices having different layouts of indicia on the indicator panel but the same functional structure.

It is known from German AS 1 766 550 to provide a radio receiver with a front opening in its casing in which is inserted an indicator panel carrying the tuning scale and having projections from two opposite edges that engage, at one edge in recesses in the front opening, and at the other edge in recesses in a closing strip that is swung into position with the panel and that has a small projection from its rear with a bore to receive a screw inserted from the interior of the casing, thereby to secure the indicator panel in the casing front opening once the parts have been positioned. This arrangement has several disadvantages. It requires a considerable number of parts and of manufacturing steps. Assembly is complicated by the fact that the screw must be inserted from the interior of the casing and the display panel from the exterior. Access to the screw may be obstructed by the apparatus within the casing, so that it would be difficult or impossible to replace the indicator panel without first removing the apparatus from the casing.

Accordingly, it is an object of the present invention to provide a display unit which can be easily disassembled for replacing the indicator panel.

It is a further object of the present invention to provide such a display unit which is simple in construction and can readily be manufactured at low cost.

In a display unit according to one aspect of the present invention, the display unit casing has guide means for sliding engagement with the support member which is inserted into the casing along said guide means, self-engaging securing means operating when said member is inserted into the casing, the member thereby holding the panel in co-operation with said engagement means, the support member being resiliently deformable to disengage said securing means in order to allow the member to be removed for replacement of the panel.

In a display unit according to another aspect of the invention, the support member for the indicator panel comprises a plate with a pair of opposite side portions providing tongue-and-groove connections with portions of the casing side walls facing them for guiding the support members slidingly into the casing, and co-operating detent and hook elements are provided between the support member and the casing, said elements interengaging when the support member is slid into the casing to secure the member releasably with the inserted panel held by the support member and the casing engagement means, said detent and hook elements being disengageable by pressure on the support member to allow said member to be disassembled from the casing for replacement of the indicator panel.

The present invention will now be described in more detail with reference to the accompanying drawings. In these drawings, in which like parts are designated throughout by like reference numerals:

Fig. 1 is an exploded perspective view of a display unit according to one embodiment of the present invention;

Fig. 2 is a perspective view of an indicator panel for the unit, showing the opposite side to the side shown in Fig. 1;

Fig. 3 is a plan view of a support plate shown in Fig. 1;

Fig. 4 is a cross-sectional view taken along the line IV—IV in Fig. 3;

Fig. 5 is a front view of the display unit of Fig. 1 when assembled with its associated device;

Fig. 6 is a cross-sectional view taken along the line VI—VI in Fig. 5;

Fig. 7 is a perspective view of another form of the indicator panel particularly showing its front surface;

Fig. 8 is a front view similar to Fig. 5, but in which the indicator panel of Fig. 7 is employed;

Figs. 9 and 10 are further views similar to Fig. 5, but show cases when further forms of the indicator panels are employed;

Fig. 11 is a plan view showing three different indicator panels integrally formed together;

Fig. 12 is a side view of the indicator panels shown in Fig. 11;

Fig. 13 is a cross-sectional view showing a storage compartment for storing an indicator panel for the purpose of replacement;

Fig. 14 is a perspective view showing an indicator panel held in a lid plate of the storage compartment;

Fig. 15 is a view similar to Fig. 1, showing another embodiment of the present invention;

Fig. 16 is a fragmentary view showing the manner in which the indicator panel is held in the unit of Fig. 15;

Fig. 17 is a cross-sectional view of the assembled display unit of Fig. 15.

Before the description of the illustrated embodiments of the present invention proceeds, it is to be noted that these are directed by way of example to display units for use in an audio device including radio receiver and possibly also a cassette device, designed for being mounted in a vehicle. The invention is also applicable, however, to display units having removable panels for other purposes and for use in other machines and devices.

Referring to Fig. 1, the display unit according to the present invention includes a panel casing 2, an indicator panel 4, a guard plate 6 and a support plate 8, each of which are described in detail below.

The indicator panel 4 made of a transparent synthetic resin plate has an elongated rectangular shape defined by four side edges 4*a*, 4*b*, 4*c* and 4*d*. Three square recesses 10*a*, 10*b* and 10*c* are formed in the longitudinal side edge 4*d* at predetermined intervals with each other. The indicator panel 4 has three engagement projections 12*a*, 12*b* and 12*c* extending from the side edge 4*b*; the projections 12*a* and 12*c* are positioned at opposite end portions of the side edge 4*b*; and the projection 12*b* is positioned approximately at the centre portion of the side edge 4*b*. The indicator panel 4 further has four engagement projections 14*a*, 14*b*, 14*c* and 14*d* extending from the side edge 4*d*; the projections 14*a* and 14*d* are positioned at opposite end portions of the side edge 4*d*; the projection 14*b* is positioned between the recesses 10*a* and 10*b*; and the projection 14*c* is positioned between the recesses 10*b* and 10*c*.

The indicator panel 4 shown in Fig. 1 has indicia, such as numbers and characters, so depicted on its front surface as to be in the correct readable position when the indicator panel 4 is disposed with its longer edges horizontally as shown. The indicator panel 4 has on its back as shown in Fig. 2, a rectangular plate 16 made of a transparent synthetic resin rigidly mounted on, or integrally formed with, the back surface.

According to a preferred embodiment, the indicator panel 4 has small through-holes 18*a* and 18*b* formed adjacent to the engagement projections 14*a* and 14*d*, respectively, for the passage of light.

The guard plate 6 made of a transparent synthetic resin plate has, when viewed from front, exactly the same configuration as that of the indicator panel 4 so that the guard plate 6 exactly overlies the front surface of the indicator panel 4. More specifically, the guard plate 6 has three recesses 20*a*, 20*b* and 20*c* corresponding to the recesses 10*a*, 10*b* and 10*c*, respectively, of the indicator panel 4, three engagement projections 22*a*, 22*b* and 22*c* corresponding to the engagement projections 12*a*, 12*b* and 12*c*, respectively, of the indicator panel 4, and four engagement projections 24*a*, 24*b*, 24*c* and 24*d*, corresponding to the engagement projections 14*a*, 14*b*, 14*c* and 14*d*, respectively, of the indicator panel 4.

The support plate 8 made of a synthetic resin includes a main plate 26 having a trapezoid shape defined by four side edges 26*a*, 26*b*, 26*c* and 26*d*, as best shown in Fig. 3, in which the side edges 26*a* and 26*c* are parallel to each other but the side edge 26*a* is longer than the side edge 26*c*. A wall 28 extends from the side edge 26*c* in perpendicular relation to the main plate 26, while a wall 30 extends from the edge of the wall 28 remote from the main plate 26, parallel to and away from the main plate 26. Since the length of the wall 30 is not as long as that of the wall 28, the wall 30 is positioned at an intermediate position between the opposite ends of the wall 28. Preferably, the front surface of the wall 30 is corrugated for facilitating a finger grip engagement. A pair of hook projections 36 and 38 extend outwards from the opposite end portions of the side edge 26*c* of the main plate 26. A pawl 36*a*, 38*a* is provided at the end of each of the hook projections 36 and 38, and extends in the same direction as the wall 28.

The supporting plate 8 further includes an elongate recess 32 extending parallel and adjacent to the side edge 26*a*, and a pair of flanges 34*a* and 34*b* extending laterally outwards from the side edges 26*d* and 26*b*, respectively, of the main plate 26.

The panel casing 2 preferably made of a synthetic resin includes a box-like casing portion 40 having four side walls 40*a*, 40*b*, 40*c* and 40*d*, and a front wall 42. A flange portion 41 extends outwards from the edge of the side walls remote from the front wall 42. The front wall 42 is formed with four small rectangular openings 44, 46, 48 and 50, in which the openings 44 and 46 are positioned side-by-side relation to each other and close to the side wall 40*b*, and the openings 48 and 50 are positioned side-by-side relation to each other and close to the side wall 40*d*. These openings are provided for receiving control buttons (not shown) provided on the audio device (not shown). The front wall 42 is further formed with an elongated rectangular opening 52 positioned between the openings 46 and 50. The opening 52 is provided for inserting a cassette tape (not shown) therethrough into a cassette device (not shown) for playing and/or recording sound.

A portion of the front wall 42 surrounded by the small rectangular openings 44 and 48 and the elongate rectangular opening 52 is formed with a recess 54 having a depth approximately equal to the sum of thicknesses of the indicator panel 4 and the guard plate 6. The bottom of the recess 54 is formed with an elongate opening 56 at a position close and parallel to the above mentioned elongate rectangular opening 52. The size of the elongate opening 56 is approximately equal to the rectangular plate 16 provided on the back of the indicator panel 4. The recess 54 is provided for receiving the indicator panel 4 and the guard plate 6, which are placed one over the other with the indicator panel 4 being directly placed on the bottom face of the recess 54, while the elongate opening 56 is provided for receiving the rectangular plate 16. An inner side wall 54*a* of the recess 54 located adjacent to the elongated rectangular opening 52 is formed with three engagement recesses 58*a*, 58*b* and 58*c*; the recesses 58*a* and 58*c* are located at opposite end portions of the inner side wall 54*a*; and the recess 58*b* is located at the centre portion of the inner side wall 54*a*. Each of the engagement recesses receives engagement projections, of the indicator panel 4 and the guard plate 6, respectively, when indicator panel 4 and guard plate 6 are accommodated in the recess 54, e.g. the recess 58*a* receives the engagement projections 12*a* and 22*a*.

An intermediate portion of the side wall 40*a* and corresponding flange portion 41*a* is formed with a recess 60 defined by a pair of inner side walls 62 and 74 for fittingly receiving therein the support plate 8. It is to be noted that the front side edge of the recess 60 remote from the flange portion 41*a* is contiguous to the adjacent side edge of the recess 54. The distance between the side walls 62 and 64 is largest at the front and is gradually narrowed towards back where the flange portion 41*a* is located. More particularly, the distance between the front edges of the side walls 62 and 64, which are in alignment with the front wall 42, is approximately equal to the length of the side edge 26*a* of the support plate 8, while the distance between rear edges of the side walls 62 and 64, which are aligned with the flange portion 41*a*, is approximately equal to the length of the side edge 26*c* of the support plate 8. The side walls 62 and 64 are formed with grooves 62*a* and 64*a*, respectively, for the engagement with the flanges 34*a* and 34*b*.

The bottom of the recess 60 is formed with two elongate openings 66 and 68 along the side walls 62 and 64, respectively. Each of the openings 66 and 68 extends from the flange porton 41*a* to the front side edge of the recess 60 and further extends into the bottom of the recess 54 in an arched shape. According to a preferred embodiment, each of the openings 66 and 68 is slightly extended into a wall defining the flange portion 41*a* for forming respective engagement edges at portions 66*a* and 68*a*. The elongate openings 66 and 68 provide paths for the hook projections 36 and 38 when the support plate 8 is to be slidingly inserted in the recess 60 in a manner which will be described later. The bottom face of the recess 60 is further formed with three elongate openings 70*a*, 70*b* and 70*c* at a predetermined interval with each other. Each of the openings 70*a*; 70*b* and 70*c* extends parallel to each other and further continues into the bottom face of the recess 54 in a square shape. It is to be noted that these square shaped openings in the bottom of the recess 54 correspond to the square openings 10*a*, 10*b* and 10*c* formed in the indicator panel 4 and also to the square openings 20*a* 20*b* and 20*c* formed in the guard plate 6. The openings 70*a*, 70*b* and 70*c* are provided for receiving actuator buttons (not shown) provided on the audio device (not shown) to be coupled with the display unit of the present invention.

For the purpose of passage of light, the bottom wall of the recess 54 is formed with small through-holes 72*a* and 72*b* adjacent to the openings 68 and 66, respectively. These small through-holes 72*a* and 72*b* register, when the indicator panel 4 is mounted in the recess 54, with the small through-holes 18*a* and 18*b* formed in the indicator panel 4. Light emitted from the audio device passes through these small through-holes for the indication of a certain actuated condition of the audio device.

For coupling the display unit with the audio device, four circular openings 74*a*, 74*b*, 74*c* and 74*d* are provided at four corners of the flange portion 41.

Now the manner for assembling the display unit will be described. First, the indicator panel 4 is fitted into the recess 54 from the front, i.e. the exterior face, of the casing with its rectangular plate 16 accommodated in the elongate opening 56 and its engagement projections 12*a*, 12*b* and 12*c* inserted in the engagement recesses 58*a* 58*b* and 58*c* respectively. Then, the guard plate 6 is placed over the indicator panel 4 with its square recesses 20*a*, 20*b* and 20*c* aligned with the square recesses 10*a*, 10*b* and 10*c*, respectively, in the indicator panel 4. In this step, the engagement projections 22*a*, 22*b* and 22*c* of the guard plate 6 are also inserted in the engagement recesses 58*a*, 58*b* and 58*c*, respectively. Finally, the support plate 8 is slid into the recess 60 with its flanges 34*a* and 34*b* sliding along the grooves 62*a* and 64*a* respectively, until the walls 30 and 28, arranged so as to assume an L-shape in cross-section, engage with the flange portion 41*a*. When the support plate 8 is inserted into the recess 60 in the manner described above, the hook projections 36 and 38 engage with the engagement edges 66*a* and 68*a*, respectively, for preventing the support plate 8 from being slid out from the inserted position, while the elongated recess 32 receives the engagement projections 14*a*, 14*b*, 14*c* and 14*d* of the indicator panel 4 and also the engagement projections 24*a*, 24*b*, 24*c* and 24*d* of the guard plate 6 for preventing the guard plate 6 and the indicator panel 4 from being displaced from the recess 54.

After the completion of the assembly as described above, the display unit is mounted on an audio device A by the use of securing screws 76*a*, 76*b*, 76*c* and 76*d*, as shown in Fig. 5. It is needless to say that the display unit can be assembled after the panel casing 2 has been mounted on the audio device A. The audio device A thus mounted with display unit is now ready for being horizontally mounted on the dashboard (not shown) of the vehicle so as to locate the side wall 40*a* of the casing portion 40 at the bottom of the casing portion 40.

When it is desired to mount the audio device A with its longer edges vertically on the dashboard, the orientation of the indicia on the indicator panel 4 should be changed. For this purpose, the display unit is disassembled to replace the indicator panel 4 with another panel in a manner described below.

To disassemble the display unit, first, the wall 30 of the support plate 8 is pressed towards the body of the panel casing 2. Since the support plate 8 is made of a material having some resiliency, the pressure applied to the wall 30 disengages the pawls 36*a* and 38*a* of the hook projections 36 and 38, respectively, from the engagement edges 66*a* and 78*a*. With the pressure being so applied to the wall 30, the support plate 8 is then pushed forward in the direction indicated by an arrow on the wall 30 for detaching the support plate 8 from the panel casing 2. Thereafter, the guard plate 6 and the indicator panel 4 are removed from the panel casing 2 without any difficulty. The casing 2 can remain attached to the audio device A, however. After the display unit has been disassembled in the manner described above, the indicator panel 4 is replaced with another type of the indicator panel 4X, as shown in Fig. 7. The indicator panel 4X has the indicia so depicted on its front surface as to be in the correct readable position when the indicator panel 4 is held vertically. Then, the display unit is assembled again in the manner described above and, in turn, the audio device A is vertically mounted on the dashboard, as shown in Fig. 8, so as to locate the side wall 40*b* of the casing portion 40 at the bottom of the casing portion 40.

It is to be noted that an indicator panel 4 of yet another form can be selected for use in the display unit when the audio device A is to be set in another position. For example, when the audio device A shown in Fig. 5 is to be mounted inverted in the dashboard, the indicator panel 4Z as shown in Fig. 10 is utilized.

As understood from the foregoing, the form of indicator panel 4 can be selected or exchanged in consideration of the type and disposition of the audio device.

When packing the audio device employing a display unit of the present invention, one form of indicator panel e.g. 4, may be operatively mounted on the panel casing 2 while the other forms of indicator panels, e.g. 4X may be attached to the audio device as accessories. However, according to the above, the different indicator panels in the step of packing, must be stocked separately for preventing the same form of indicator panels being packed in the same package. Thus, it is necessary to maintain the various forms of indicator panels under control Furthermore, it is necessary to note down how many and what forms of indicator panel are packed in each package. For avoiding such time consuming operations, it is preferable to prepare the indicator panels of different forms in one integral element as described below.

Referring to Figs. 11 and 12, there is shown an integral element 80 constituted by three indicator panels 4X, 4 and 4Y having different layouts of the indicia. The integral element 80 is formed by moulding and can be easily snapped apart or otherwise divided at thin jointing portions 82 for separating the indicator panels 4X, 4 and 4Y. In the process of manufacturing the display unit, the indicator panels are produced in the form of integral elements, as shown in Figs. 11 and 12, each integral element including a number of indicator panels having different layouts of the indicia. When the display unit is ready for assembly, the integral element is divided in the manner described above, and one indicator panel is selected for use in the display unit. The remaining indicator panels should preferably be attached to the audio device in a manner described below.

Since the different forms of indicator panels are produced as a unitary structure, namely, an integral element, they can be maintained as a single element, at the packing stage, and one integral element packed in each package. When installing the audio unit, the integral element is divided in the manner described above for selecting and mounting a desired indicator panel into the panel casing 2. For instructing the user, it is preferable to provide a note stating "Separate the indicator panels by breaking at the weakened sections and mount the required indicator panel on the casing", between the panel casing 2 and the guard panel 6. If the indicator panels are provided separately in the package, the ones which are not in use may be lost or may even be overlooked during the packing. For avoiding such an disadvantage, the remaining panels which are not in use should preferably be held in a storage compartment.

Referring to Figs. 13 and 14, a storage compartment for storing an indicator panel is constituted by a rectangular recess 84 formed in one side wall of the audio device A and a lid plate 86 for closing the rectangular recess 84. An L-shaped hook 88*a* is rigidly mounted on the lid plate 86 at a position closely adjacent to one side edge thereof and projects thereform in a direction perpendicular to one flat surface of the lid plate 86. Similarly, L-shaped hooks 88*b* and 88*c* are rigidly mounted on the lid plate 86 at positions closely adjacent to the other side edge opposite to the above-mentioned side edge. Four supporting arms 90*a*, 90*b* 90*c* and 90*d*

project from the same flat surface of the lid plate 86 for supporting the indicator panel in a manner as shown in Fig. 14. The lid plate 86 carrying the indicator panel is placed over the recess 84 with the surface carrying the indicator panel facing the recess 84. The recess 84 has engagement openings 92 at positions corresponding to the engagement hooks 88*a*, 88*b* and 88*c* for keeping the lid plate 86 in the closed condition. For detaching the lid plate 86 from the recess 84, the engagement hook e.g. 88*a* is forcibly bent towards the plate 86 by the insertion of a coin or the like into a space between the edge of the lid plate 86 and the side wall defining the recess 84.

Referring to Fig. 15, there is shown another embodiment of display unit according to the invention. According to this embodiment two indicator panels 4 and 4X are joined together at a common side edge formed with square recesses 10*a*, 10*b* and 10*c*, to assume an L-shaped cross-section. At their remote longer side edges each panel has projections corresponding to the projections 12*a*, 12*b*, 12*c* of the first-described embodiment. When one indicator panel, e.g., 4 is held in the recess 54 in the manner described above, the other indicator panel 4X is accommodated in the recess 60. For this purpose, the recess 60 in this embodiment is formed larger than the recess 60 of the previous embodiment as described below.

The bottom of the recess 60 is defined by four arms 94, each comprising a stop element 94*a* and a retaining element 94*b* protruding outwards from the stop element 94*a* and lying in a plane offset relative to the stop element 94*a*, as best shown in Fig. 16. When the indicator panel 4X, for example, is inserted in the recess 60 from the front, the edge of the panel 4X is held in contact with the stop elements 94*a* and, at the same time, the back surface of the indicator panel 4X adjacent to the edge is held in contact with the retaining elements 94*b*.

After the indicator panels 4 and 4X are accommodated in the respective recesses 54 and 60, the support plate 8 is inserted into the recess 60 slidingly over the front surface of the indicator panel 4X, and is engaged in the inserted position in the manner already described above.

According to this embodiment, when the support plate 8 is inserted into the recess 60, the panel 4 is retained in the recess 54 and panel 4X in the recess 60.

When it is desired to change the layout of the indicia from horizontal alignment to vertical alignment, the position of the indicator panels 4 and 4X is changed over. For fittingly matching both indicator panels 4 and 4X in the recess 54, the configuration of the indicator panels 4 and 4X should be symmetrical about an imaginary line extending between the centre of the side edge 4*b* and the centre of the side edge 4*d* of each indicator panel.

Since the display unit according to the present invention can be simply disassembled, even after it is mounted on the audio device, the indicator panel can be exchanged for any desired form. Therefore, when the display unit of the present invention is employed, it is possible to select a desired layout of the indicia for the display unit in consideration of the type and disposition of the device.

It is to be noted that a display unit of the present invention can be arranged to be mounted on machines or devices other than audio devices referred to above.

Although the present invention has been fully described with reference to preferred embodiments, many modifications and variations thereof will now be apparent to those skilled in the art.

## Claims

1. A display unit having a casing (2) formed with a recess or opening (54, 56) and a removable indicator panel (4) adapted to be mounted therein from the exterior and to be held in place by engagement means (58) in the casing and by a support member (8) removably secured to the casing, characterised in that the casing has guide means (62a, 64a) for sliding engagement with the support member which is inserted into the casing along said guide means, self-engaging securing means (36, 38, 66a, 68a) operating when said member is inserted into the casing, the member thereby holding the panel in co-operation with said engagement means, the support member being resiliently deformable to disengage said securing means in order to allow the member to be removed for replacement of the panel.

2. A display unit as claimed in claim 1, provided with alternative removable panels (4, 4X) of elongate configuration and bearing indicia so arranged that one panel is in the correct readable position when it is held with its longer edges horizontal, and the other panel is in the correct readable position when it is held with its longer edges vertical.

3. A display unit as claimed in claim 1 or claim 2, wherien the panel (4) comprises an indicator panel plate bearing indicia and a guard plate (6) placed over said panel plate.

4. A display unit as claimed in any one of claims 1 to 3, comprising an integral structure (80) of a plurality of indicator panel plates (4, 4X, 4Y) that is severable for separating the individual panel plates in it.

5. A display unit as claimed in any one of the preceding claims, wherein the panel has engagement projections (12a, 12b, 12c, and 14a, 14b, 14c, 14d) on opposite edge regions and the casing and the support member are provided with recesses (58a, 58b, 58c and 32) with which said projections are engaged.

6. A display unit as claimed in any one of the preceding claims wherein the casing comprises first and second walls (42, 40a) having a common junction region so as to assume a generally L-shaped cross-section, said first and second walls each having openings or recesses (54, 56 and 60, 66, 68) in their regions extending away from said junction region, the panel being locatable in the first wall opening or recess and the support member (8) being in the form of a plate locatable in the second wall opening or recess.

7. A display unit as claimed in claim 6, wherein opposed edges (62, 64) of said opening or recess in the second wall converge from a larger spacing adjacent said junction region to a narrower spacing away from said junction region.

8. A display unit as claimed in claim 6 or claim 7 wherein the guide means for the detachable support plate comprising grooves (62a, 64a) at opposed edges of the second wall opening or recess.

9. A display unit as claimed in any one of the preceding claims, wherein the removable support member (8) is automatically secured to the casing by co-operating detent and hook elements (36, 38 and 66a, 68a).

10. A display unit as claimed in any one of the preceding claims, comprising a composite panel structure having respective integrally connected panels (4, 4X) and assuming a generally L-shaped cross-section, engagement means being formed on edge portions of each of said panels remote from their interconnection, and said panel support member (8) being arranged to engage the panel structure in the region of said interconnection.

11. A display unit as claimed in claim 10, wherein said two panels of the structure have an identical rectangular shape and are interconnected at respective longer side edges.

12. A display unit as claimed in any one of the preceding claims, wherein a storage compartment (84) is formed in a wall of the casing for storing a removable panel (4) therein.

13. A display unit as claimed in claim 12, wherein said storage compartment comprises a recess (84) formed in said wall and a lid plate (86) engaging said wall covering the recess, holding means (90a, 90b, 90c, 90d) being provided for said removable panel on the surface of the lid plate facing said recess.

14. A display unit having a casing (2) formed with a recess or opening (54, 56) and a removable indicator panel (4) adapted to be mounted therein from the exterior and to be held in place by engagement means (58) in the casing and by a support member (8) removably secured to the casing, characterised in that the support member (8) comprises a plate with a pair of opposite side portions (34a, 34b) providing tongue-and-groove connections with portions (62a, 64a) of the casing side walls facing them for guiding the support member slidingly into the casing, and cooperating detent and hook elements (36, 38, 66a, 68a) are provided between the support member and the casing, said elements interengaging when the support member is slid into the casing to secure the member releasably with the inserted panel held by the support member and the casing engagement means, said detent and hook elements being disengageable by pressure on the support member to allow said member to be disassembled from the casing for replacement of the indicator panel.

## Revendications

1. Unité d'affichage ayant un boîtier (2) présentant un évidement ou ouverture (54, 56) et un panneau indicateur amovible (4) pouvant y être monté à partir de l'extérieur et y être maintenu en place par un moyen d'engagement (58) dans le boîtier et par un organe de support (8) fixé amovible au boîtier, caractérisée en ce que le boîtier a un moyen de guidage (62*a*, 64*a*) pour un engagement coulissant avec l'organe de support qui est inséré dans le boîtier le long dudit moyen de guidage, un moyen de fixation à auto-engagement (36, 38, 66*a*, 68*a*) fonctionnant quand ledit organe est inséré dans le boîtier, l'organe maintenant ainsi le panneau en coopération avec ledit moyen d'engagement, l'organe de support étant élastiquement déformable pour dégager ledit moyen de fixation afin de permettre à l'organe d'être retiré pour un remplacement du panneau.

2. Unité d'affichage selon la revendication 1, pourvu d'autres panneaux amovibles (4, 4X) de configuration allongée et portant des indices agencés de façon qu'un panneau soi à la position lisible correcte lorsqu'il est maintenu avec ses bords longs horizontaux, et l'autre panneau soit en position lisible correcte lorsqu'il est maintenu avec ses bords longs verticaux.

3. Unité d'affichage selon la revendication 1 ou la revendication 2, où le panneau (4) comprend une plaque de panneau indicateur portant des indices et une plaque de garde (6) placée au-dessus de ladite plaque de panneau.

4. Unité d'affichage selon l'une quelconque des revendications 1 à 3, comprenant une structure intégrale (80) d'un certain nombre de plaques de panneau indicateur (4, 4X, 4Y) séparable pour séparer les plaques individuelles de panneau.

5. Unité d'affichage selon l'une quelconque des revendications précédentes, où le panneau a des protubérances d'engagement (12*a*, 12*b*, 12*c* et 14*a*, 14*b*, 14*c*, 14*d*) sur des régions latérales et opposées et le boîtier et l'organe de support sont pourvus d'évidements (58*a*, 58*b*, 58*c* et 32) avec lesquels lesdites protubérances viennent en engagement.

6. Unité d'affichage selon l'une quelconque des revendications précédentes, où le boîtier comprend des première et seconde parois (42, 40*a*) ayant une région commune de jonction afin d'avoir une section transversale généralement en L, lesdites première et seconde parois ayant chacune des ouvertures ou évidements (54, 56 et 60, 66, 68) dans leurs régions s'étendant au loin de ladite région de jonction, le panneau pouvant être placé dans l'ouverture ou évidement de la première paroi et l'organe de support (8) ayant la forme d'une plaque pouvant être placée dans l'ouverture ou évidement de la seconde paroi.

7. Unité d'affichage selon la revendication 6, où des bords opposés (62, 64) de ladite ouverture ou évidement dans la seconde paroi convergent d'un plus grand espace à proximité de ladite région de jonction à un espace plus étroit au loin de ladite région de jonction.

8. Unité d'affichage selon la revendication 6 ou la revendication 7, où le moyen de guidage de la plaque de support détachable comprend des gorges (62*a*, 64*a*) sur des bords opposés de l'ouverture ou évidement de la seconde paroi.

9. Unité d'affichage selon l'une quelconque des revendications précédentes, où l'organe de support amovible (8) est automatiquement fixé au boîtier par des éléments coopérants formant crans d'arrêt et crochets (36, 38 et 66*a*, 68*a*).

10. Unité d'affichage selon l'une quelconque des revendications précédentes, comprenant une structure de panneau composée ayant des panneaux respectifs intégralement connectés (4, 4X) et ayant une section transversale généralement en L, un moyen d'engagement étant formé sur les parties de bordure de chacun desdits panneaux au loin de leur interconnexion, et ledit organe de support de panneau (8) étant agencé pour engager la structure de panneau dans la région de ladite interconnexion.

11. Unité d'affichage selon la revendication 6 où les deux panneaux de la structure ont une forme rectangulaire identique et ils sont interconnectés à leurs bords latéraux longs respectifs.

12. Unité d'affichage selon l'une quelconque des revendications précédentes où un compartiment de stockage (84) est formé dans une paroi du boîtier pour y stocker un panneau amovible (4).

13. Unité d'affichage selon la revendication 12, où ledit compartiment de stockage comprend un évidement (84) formé dans ladite paroi et une plaque formant couvercle (86) engageant ladite paroi couvrant l'évidement, un moyen de maintien (90*a*, 90*b*, 90*c*, 90*d*) étant prévu pour ledit panneau amovible sur la surface de la plaque de couvercle faisant face audit évidement.

14. Unité d'affichage ayant un boîtier (2) avec un évidement ou ouverture (54, 56) et un panneau indicateur amovible (4) pouvant y être monté de l'extérieur et y être maintenu en place par un moyen d'engagement (58) dans le boîtier et par un organe de support (8) fixé amovible au boîtier, caractérisée en ce que l'organe de support (8) comprend une plaque ayant deux parties latérales et opposées (34*a*, 34*b*) formant des connexions à langue et gorge avec des parties (62*a*, 64*a*) des parois latérales du boîtier leur faisant face pour guider l'organe de support de manière coulissante dans le boîtier, et des éléments coopérants formant crans d'arrêt et crochets (36, 38, 66*a*, 68*a*) sont prévus entre l'organe de support et le boîtier, lesdits éléments venant en engagement quand l'organe de support est glissé dans le boîtier pour maintenir amovible l'organe avec le panneau inséré maintenu par l'organe de support et le moyen d'engagement du boîtier, lesdits éléments formant crans d'arrêt et crochets pouvant être dégagés par pression sur l'organe de support pour permettre audit organe d'être démonté du boîtier pour remplacement du panneau indicateur.

**Patentansprüche**

1. Anzeigeeinheit mit einem Gehäuse (2) mit einer Ausnehmung oder Öffnung (54, 56) und mit einer auswechselbaren Anzeigeplatte (4), die von außen in diese eingesetzt und durch Eingriffsmittel (58) im Gehäuse und ein am Gehäuse lösbar befestigtes Halteteil (8) festgelegt werden kann, dadurch gekennzeichnet, daß das Gehäuse Führungsmittel (62a, 64a) aufweist für einen Schiebeeingriff mit dem Halteteil, welches entlang den Führungsmitteln in das Gehäuse eingeführt wird, wobei selbsttätig zum Eingriff kommende Sicherungsmittel (36, 38, 66a, 68a) worksam werden, wenn das Halteteil (8) in das Gehäuse eingeführt wird, wodurch das Halteteil die Anzeigeplatte im Zusammenwirken mit den Eingriffsmitteln hält, und daß das Halteteil elastisch verformbar ist, um die Sicherungsmittel außer Eingriff zu bringen, um das Halteteil für das Auswechseln der Anzeigeplatte aus dem Gehäuse herausnehmen zu können.

2. Anzeigeeinheit nach Anspruch 1, dadurch gekennzeichnet, daß es mit alternativen auswechselbaren Skalenplatten (4, 4X) von länglicher Konfiguration versehen ist, die die Anzeigesymbole tragen, die so angeordnet sind, daß die eine Skalenplatte in der richtigen lesbaren Stellung ist, wenn ihre längeren Kanten horizontal liegen, und die andere in der korrekten lesbaren Stellung ist, wenn ihre längeren Kanten vertikal liegen.

3. Anzeigeeinheit nach Anspruch 1 oder 2, dadurch gekennzeichnet, daß die Platte (4) eine Skalenplatte mit Anzeigesymbolen und eine Schutzplatte (6) aufweist, die über der Skalenplatte (1) angeordnet ist.

4. Anzeigeeinheit nach Anspruch 1 bis 3, dadurch gekennzeichnet, daß sie eine einstückige Struktur (80) aufweist, mit einer Vielzahl von Skalenplatten (4, 4X, 4Y), die voneinander lösbar sind, um die einzelnen Skalenplatten darin voneinander zu trennen.

5. Anzeigeeinheit nach einem der vorangehenden Ansprüche, dadurch gekennzeichnet, daß die Skalenplatte Eingriffsvorsprünge (12a, 12b, 12c und 14a, 14b, 14c, 14d) in einander gegenüberliegenden Kantenbereichen aufweist und daß das Gehäuse und das Halteteil mit Ausnehmungen (58a, 58b, 58c und 32) versehen sind, in welche die Vorsprünge eingreifen.

6. Anzeigeeinheit nach einem der vorangehenden Ansprüche, dadurch gekennzeichnet, daß das Gehäuse eine erste und eine zweite Wand (42, 40a) aufweist, die einen gemeinsamen Verbindungsbereich aufweisen, so daß sie einen im wesentlichen L-förmigen Querschnitt annehmen, wobei die erste und zweite Wand jeweils Öffnungen oder Ausnehmungen (54, 56 und 60, 66, 68) in ihren vom Verbindungsbereich sich erstreckenden Bereichen aufweisen, wobei die Skalenplatte in der ersten Wandöffnung oder -ausnehmung und das Halteteil (8) in der Form einer Platte in der zweiten Wandöffnung oder -ausnehmung untergebracht werden kann.

7. Anzeigeeinheit nach Anspruch 6, dadurch gekennzeichnet, daß gegenüberliegende Kanten (62, 64) der Öffnung oder Ausnehmung in der zweiten Wand von einem grösseren Abstand nahe des Verbindungsbereiches zu einem kleineren Abstand entfernt vom Verbindungsbereich konvergieren.

8. Anzeigeeinheit nach Anspruch 6 oder 7, dadurch gekennzeichnet, daß die Führungsmittel für die lösbare Halteplatte Nuten (62a, 64a) an gegenüberliegenden Kanten der zweiten Wandöffnung oder -ausnehmung aufweisen.

9. Anzeigeeinheit nach einem der vorangehenden Ansprüche, dadurch gekennzeichnet, daß das ausbaubere Halteteil (8) im Gehäuse automatisch gesichert wird, durch das Zusammenwirken von Klinken- und Hakenelementen (36, 38 und 66a, 68a).

10. Anzeigeeinheit nach einem der vorangehenden Ansprüche, gekennzeichnet durch eine zusammengesetzte Plattenstruktur, die jeweils einstückig miteinander verbundene Platten (4, 4X) aufweist und einen im wesentlichen L-förmigen Querschnitt hat, wobei Eingriffsmittel jeweils an den von ihrer Verbindung entfernt liegenden Kantenbereichen vorgesehen sind, und wobei das Plattenhalteteil (8) so angeordnet ist, daß es in die Plattenstruktur im Bereich ihrer Verbindung eingreift.

11. Anzeigeeinheit nach Anspruch 10, dadurch gekennzeichnet, daß zwei Platten der Struktur einen identischen rechtwinkligen Umriß haben und an ihren jeweiligen längeren Seitenkanten miteinander verbunden sind.

12. Anzeigeeinheit nach einen der vorangehenden Ansprüche, dadurch gekennzeichnet, daß ein Vorratsabteil (84) in einer Wand des Gehäuses vorgesehen ist zum Aufbewahren einer auswechselbaren Skalenplatte (4) darin.

13. Anzeigeeinheit nach Anspruch 12, dadurch gekennzeichnet, daß das Vorratsabteil aus einer Ausnehmung (84), die in der Wandung ausgebildet ist, und eine Deckelplatte (86), die in die Wand eingreift und die Ausnehmung abdeckt, besteht, wobei Haltemittel (90a, 90b, 90c, 90d) in der der Ausnehmung zugewandten Fläche der Deckelplatte für die auswechselbare Skalenplatte vorgesehen sind.

14. Anzeigeeinheit mit einem Gehäuse (2) mit einer Ausnehmung oder Öffnung (54, 56) und mit einer auswechselbaren Anzeigeplatte (4), die von außen in diese eingesetzt und durch Eingriffsmittel (58) im Gehäuse und ein am Gehäuse lösbar befestigtes Halteteil (8) festgelegt werden kann, dadurch gekennzeichnet, daß das Halteteil eine Platte aufweist mit einem Paar von einander gegenüberliegenden Seitenteilen (43a, 43b), die mit den ihnen zugewandten Teilen (62a, 64a) der Gehäuseseitenwände Zunge/Nut-Verbindungen bilden, um das Halteteil schiebbar in dem Gehäuse zu führen, und daß zusammenwirkende Klinken- und Hakenelemente (36, 38, 66a, 68a) zwischen dem Halteteil und dem Gehäuse vorgesehen sind, welche ineinander eingreifen, wenn das Halteteil in das Gehäuse eingeschoben wird, um das Teil lösbar zu sichern, wobei die eingesetzte Skalenplatte durch das Halteteil und die Gehäuseeingriffsmittel gehalten wird, wobei die Klinken- und Hakenelemente durch Druck auf das Halteteil außer Eingriff bringbar sind, um es zu ermöglichen, das Halteteil aus dem Gehäuse für den Austausch der Anzeigeplatte auszubauen.

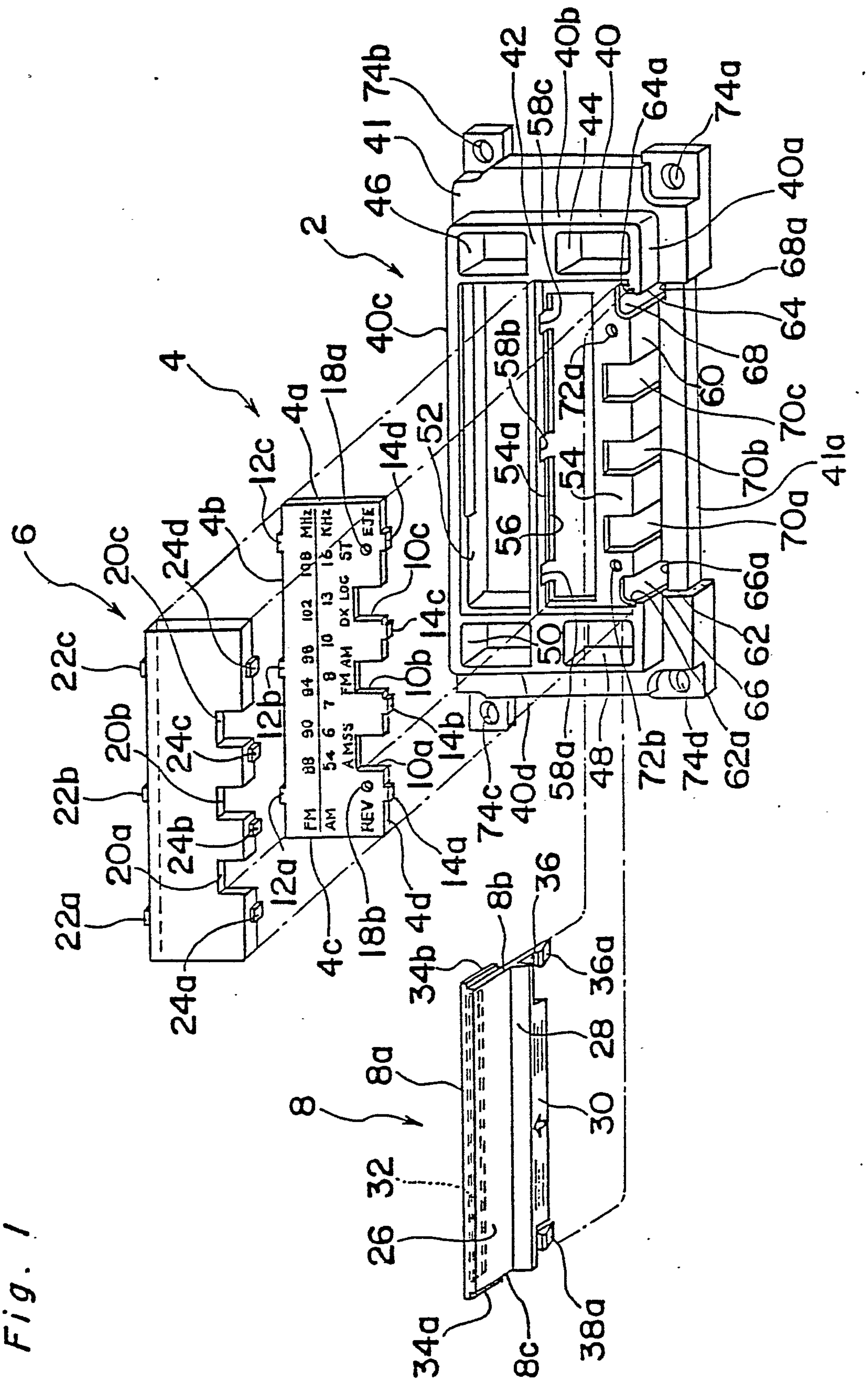
2
4
6
8
4a
4b
4c
4d
8a
8b
8c
10a
10b
10c
12a
12b
12c
14a
14b
14c
14d
18a
18b
20a
20b
20c
22a
22b
22c
24a
24b
24c
24d
26
28
30
32
34a
34b
36
36a
38a
40
40a
40b
40c
40d
41
41a
42
44
46
48
50
52
54
54a
56
58a
58b
58c
60
62
62a
64
64a
66
66a
68
68a
70a
70b
70c
72a
72b
74a
74b
74c
74d
FM
AM
MHz
KHz
REV
ST
DX
LOG
AMSS

Fig. 1

Fig. 2

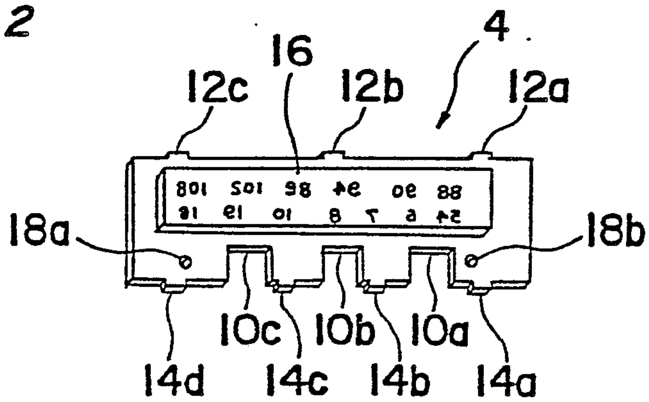


Fig. 3

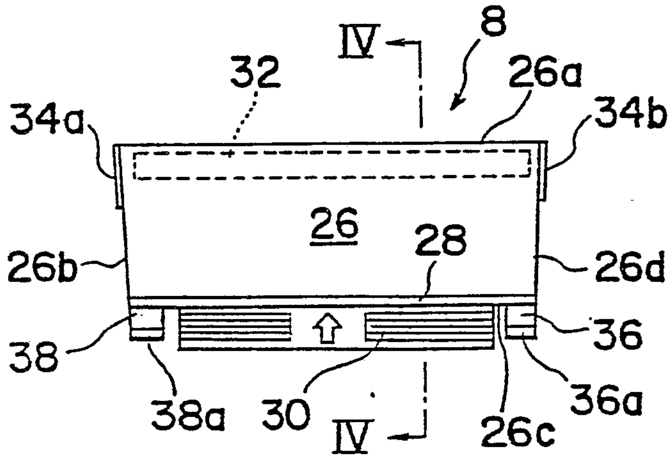


Fig. 4

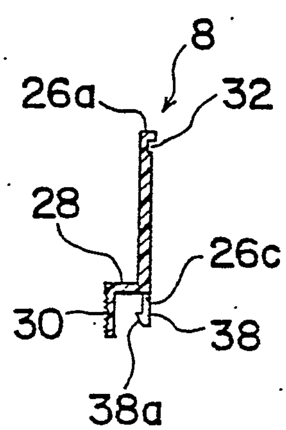


Fig. 5

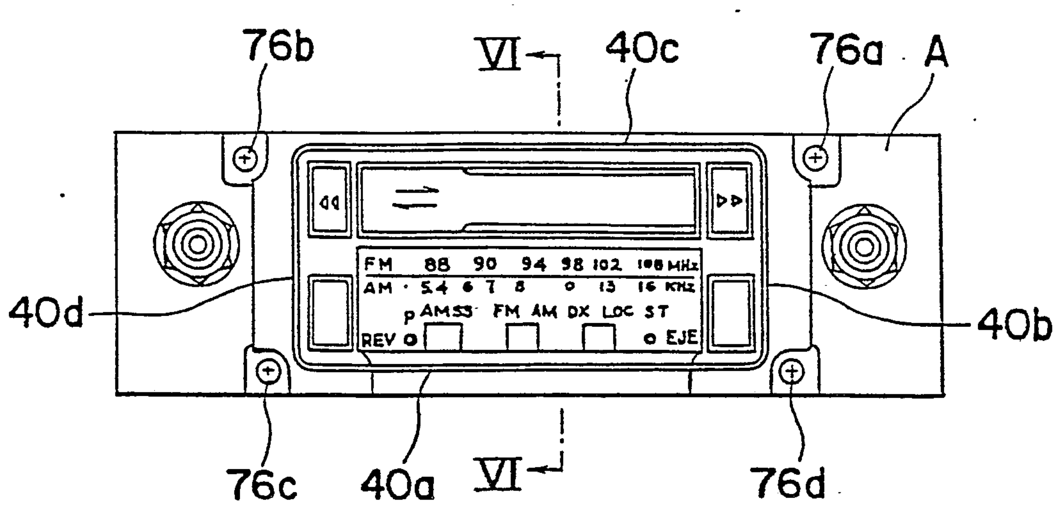

Fig. 6

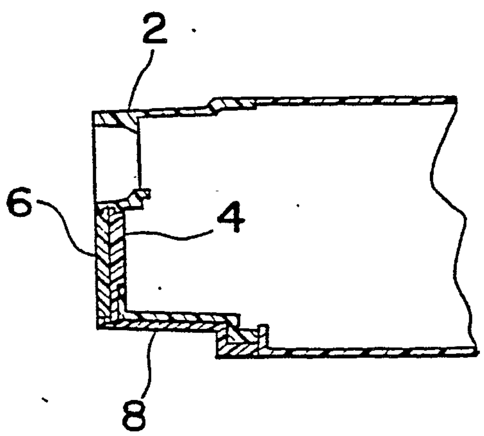


Fig. 8

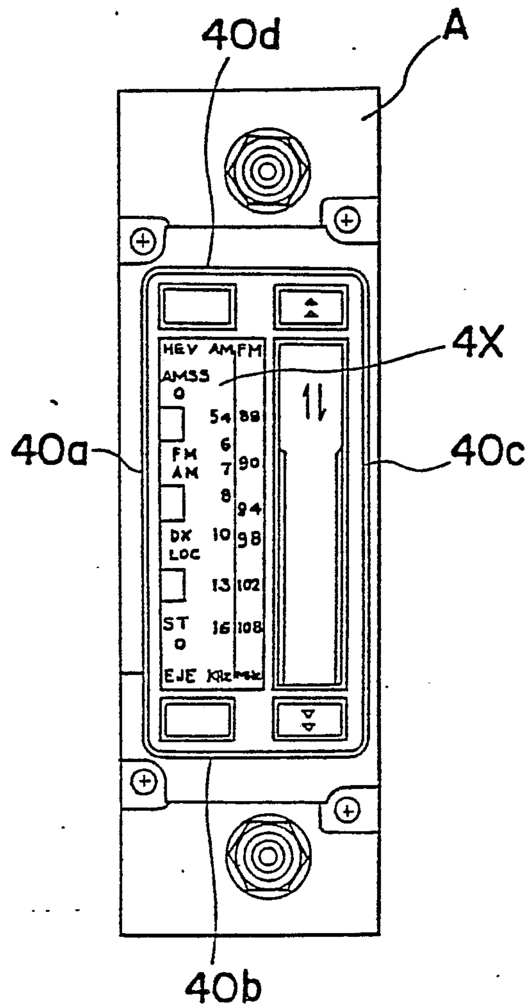


Fig. 7

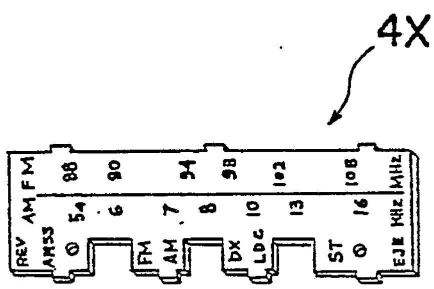


Fig. 9

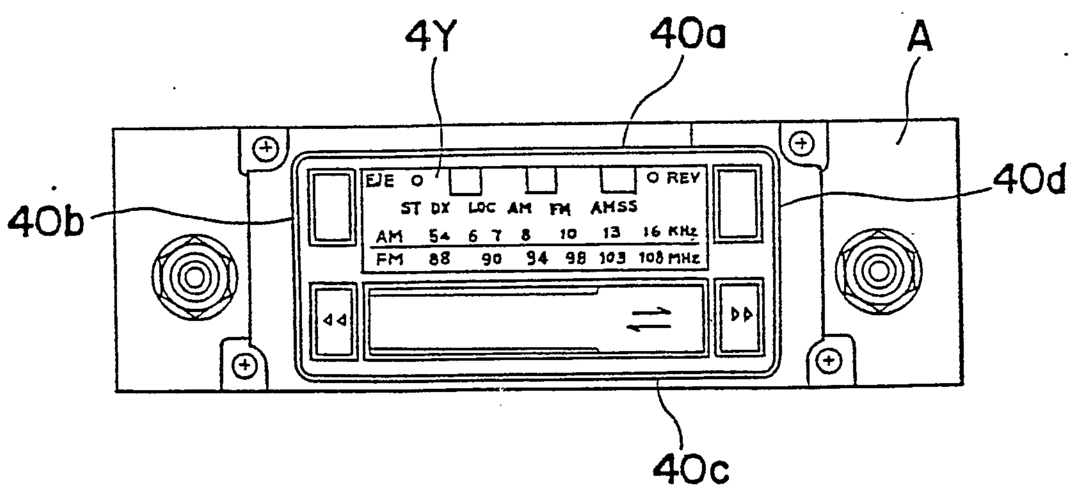

Fig. 10

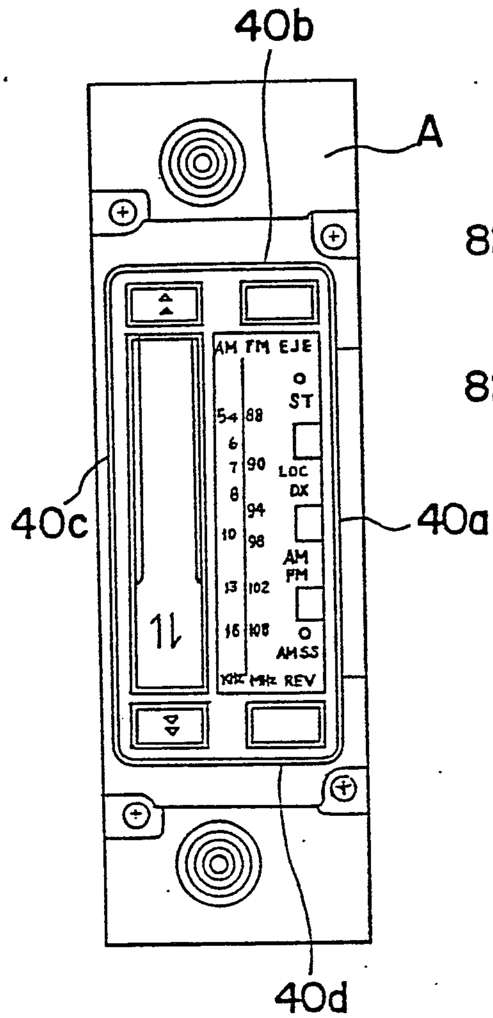


Fig. 11

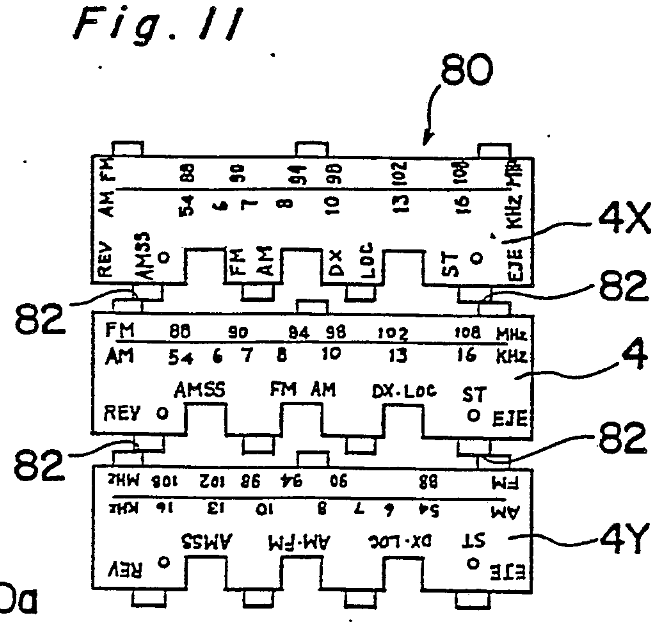


Fig. 12

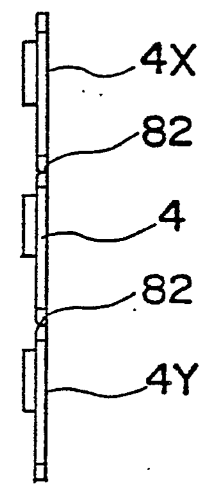


Fig. 13

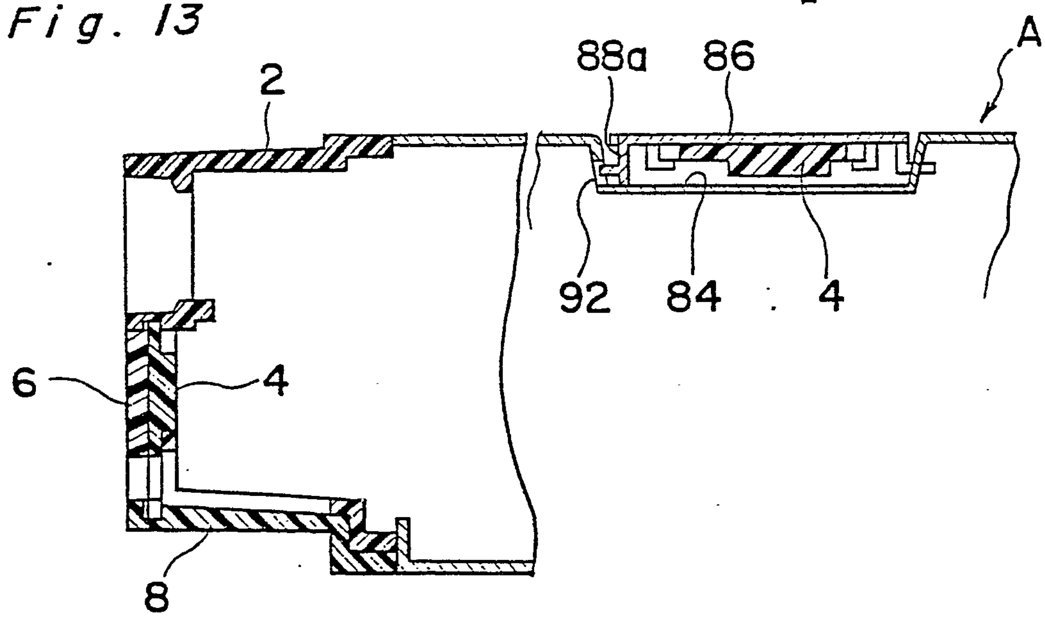

Fig. 14

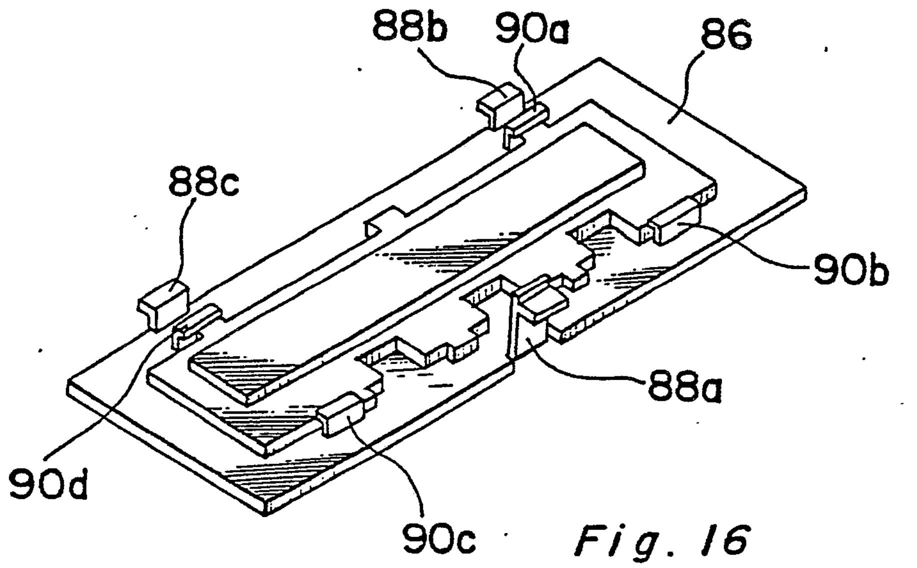


Fig. 16

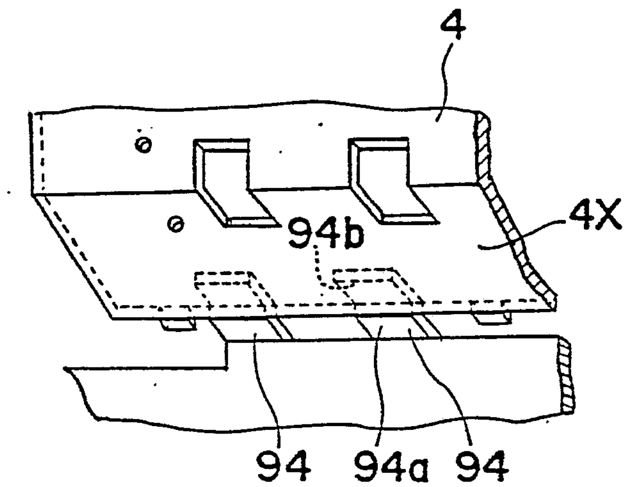


Fig. 17

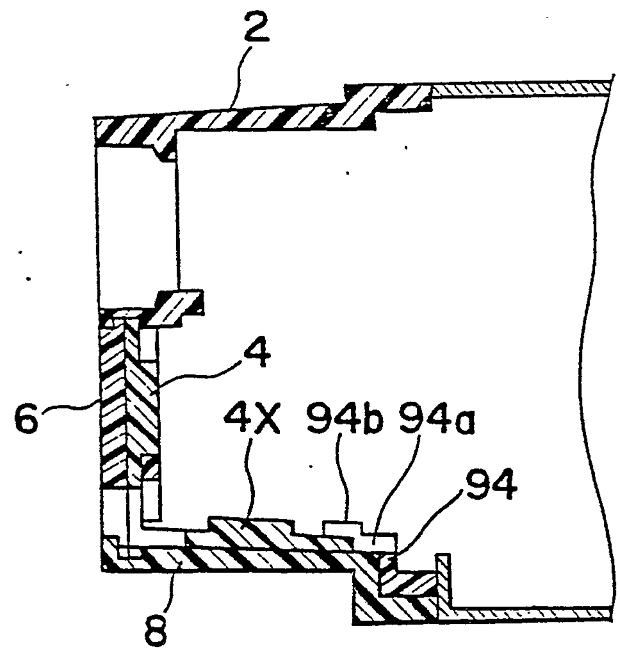

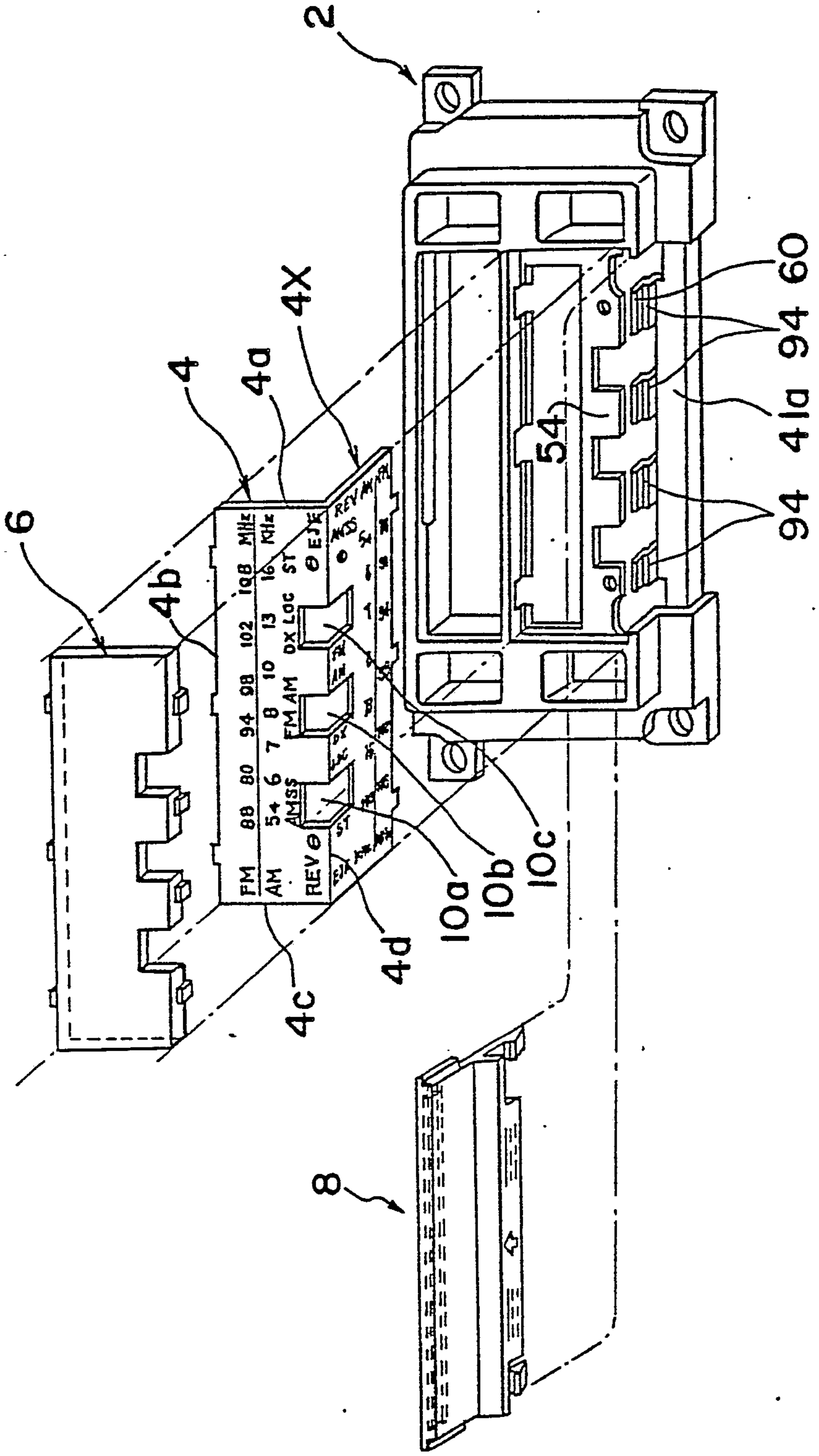


Fig. 15.